Europäisches Patentamt

European Patent Office

Office européen des brevets

(11) Publication number: **0 330 577**
**A2**

(19)

# EUROPEAN PATENT APPLICATION

(12)

(21) Application number: **89400514.9**

(22) Date of filing: **23.02.89**

(51) Int. Cl.⁴: **G 11 C 11/00**
**G 11 C 19/00**

(30) Priority: **23.02.88 JP 38719/88**

(43) Date of publication of application:
**30.08.89 Bulletin 89/35**

(84) Designated Contracting States: **DE FR GB**

(71) Applicant: **NISSAN MOTOR CO., LTD.**
**No.2, Takara-cho, Kanagawa-ku**
**Yokohama-shi Kanagawa-ken 221 (JP)**

(72) Inventor: **Ikeda, Hiroshi**
**Korugi Haitsu, 23-28 Kaminagaya 3-chome**
**Konan-ku, Yokohama-shi Kanagawa-ken (JP)**

**Fujiki, Norio**
**204-61, Hitorizawa**
**Isogo-ku, Yokohama-shi Kanagawa-ken (JP)**

**Hirota Masaki**
**Yoko Haitsu,21-17 Takafunedai 2-chome**
**Kanazawa-ku, Yokohama-shi Kanagawa-ken (JP)**

(74) Representative: **Berger, Helmut et al**
**Cabinet Z. WEINSTEIN 20, avenue de Friedland**
**F-75008 Paris (FR)**

(54) Apparatus for storing data therein.

(57) An apparatus for storing data therein is disclosed in which a plurality of memory portions ($3_1a$, $3_1b$,..., $3_1n$; $3_2a$, $3_2b$,...,$3_2n$;...; $3_na$, $3_nb$, $3_nn$) are arranged in series for storing a plurality of data on a run of the vehicle and the data stored in the memory portions are sequentially shifted toward subsequent memory portions. When such a shift operation as described above is repeated, new data are sequentially stored in the respective memory portions. In addition, when an unsteady state of the vehicle such as in case of emergency associated with the apparatus occurs, a write control circuit (18) is activated so that the data stored in the respective memory portions are protectively (in a non-volatile form) held.

FIG.1

EP 0 330 577 A2

Description

# APPARATUS FOR STORING DATA THEREIN

## BACKGROUND OF THE INVENTION

### (1) Field of the Invention

The present invention relates to an apparatus for storing data therein and particularly relates to a data storing apparatus for storing various kinds of data and for protectively holding the various kinds of data on run of a vehicle during an unsteady state (emergency) without loss of data.

### (2) Background of the art

In recent years, data storing apparatus for storing various data on a run of a vehicle is installed in the vehicle in order to analyze data stored in the data storage device so that a cause of unsteady operation of the vehicle is determined.

Various types of data storing apparata have been proposed and developed as exemplified by a Japanese Publication, an automotive engineering volume 40, No.10, pages 1337 to 1342 (in 1986), and SAE (Society of Automotive Engineers) PAPER 840437 (in 1984).

One of the various types of the data storing apparata, e.g., disclosed in the above-identified Publications will be described below.

Data on the various kinds of data on the vehicle run are stored on the basis of a control command by means of an 8-bit microcomputer. That is to say, the microcomputer is connected to a plurality of interface circuits and a plurality of timer modules via a system bus. The microcomputer processes variety of information obtained via the interface circuits and/or timer modules.

A first interface circuit transmits a switching information from a key switch to the system bus. A second interface circuit transmits a status signal to the system bus. Furthermore, one timer module 108 transmits the measured information from a fuel gage to the system bus. Another timer module transmits a speed information from a vehicle speed sensor to the system bus.

Next, a RAM (Random Access Memory) as a working area of the apparatus processes the variety of information obtained via the system bus on the basis of control commands derived from the microcomputer. A RAM as a data area sequentially stores variety of data processed by the RAM on the basis of other commands of the microcomputer. In addition, the microcomputer, e.g., diagnoses causes of unsteady operations of the vehicle on the basis of various types of data stored in the RAM. The results of diagnoses are transmitted to a display unit via a third interface circuit and a display driver to display the results of diagnoses through the display unit.

In the above-described data storing apparatus, in a case where the unsteady operation should occur and/or an accident or trouble should occur, a secondary battery is used to back up the second RAM, or an Erasable Programmable Read Only Memory (EPROM), Electrically Erasable Programmable Read Only Memory (EEPROM), or Non-volatile Random Access Memory (NVRAM) is used as storage means for storing the various data in order to ensure and protect the storage of data.

The EEPROM includes address buffers into which an addressing is inputted (,i.e., an address of data to be written is specified) from the microcomputer, a row decoder and column decoder by means of which a particular memory cell of the memory array is specified by means of the row decoder and column decoder. Write or read of data is executed in response to a high voltage on the basis of a signal derived from a control circuit for the specified memory cell.

However, since the EEPROM stores data composed of a plurality of bits for each one bit and reads the data stored for each one bit, a long time is required to execute the data write and read in a case when a large amount of data is handled. Therefore, the protection of data in a unsteady operation of the vehicle often becomes difficult.

The NVRAM has, in turn, been used in which the RAM and EEPROM are integrated onto a single chip.

The NVRAM usually functions as the RAM and can read or write the data at high speeds from a Random Access portion thereof. In addition, according to its necessity, an NV (Non-volatile) signal to command the write of data is supplied to one input terminal of a logical product circuit in the case of unsteady operation (or emergency) so that the write of data from the Random Access portion to the non-volatile portion is executed at a high speed.

Although the NVRAM used as the data storing means can shorten a time required for the write of data in case of emergency, one of the addresses needs to be specified when the data is stored into the Random Access Memory portion. Therefore, a processing required to store the data becomes complicated.

Although a custom NVRAM may be used in which each address is automatically generated during the write of data into the specified address, a circuit construction at a periphery of the custom NVRAM becomes complicated and the cost accordingly becomes increased.

On the other hand, an LSI (Large Integrated Circuit) composed of a plurality of so-called CMOS (Complementary Metal Oxide Semiconductor) transistor circuits are used as memory cells of the second RAM to store the data on the run of the vehicle.

A limit is provided for a quantity of data to be stored per chip and therefore an improvement is needed for the storing means for storing the large quantity of various data on the run of the vehicle.

## SUMMARY OF THE INVENTION

It is an object of the present invention to provide a data storing apparatus which is simple in construction, easily and quickly stores the large amount of various data on the run of the vehicle, and can protectively hold the data without loss of data in the case of an unsteady operation of the vehicle.

The above-described object can be achieved by providing an apparatus for storing data therein, comprising: a) first means for producing and outputting a clock pulse signal having a predetermined period; b) second means for controlling a plurality of data, each having a plurality of bits, to be inputted into the data storing apparatus in synchronization with the clock pulse signal; and c) third means having a plurality of data memory portions for storing respective bits of data and for shifting the respective bits of data toward the subsequent data memory portions thereof in synchronization with the clock pulse signal.

The above-described object can also be achieved by providing an apparatus for storing data on a run of a vehicle therein, comprising: a) first means for producing and outputting a clock pulse signal having a predetermined period; b) second means for controlling a plurality of data, each data having a plurality of bits, to be inputted into the data storing apparatus in synchronization with the clock pulse signal; c) third means having a plurality of data memory portions for storing respective bits of data and for shifting the respective bits of data toward the subsequent data memory portions thereof in synchronization with the clock pulse signal.

## BRIEF DESCRIPTION OF THE DRAWINGS

Fig.1 is a circuit block diagram of a first preferred embodiment of a data storing apparatus according to the present invention.

Fig. 2 is a circuit block diagram indicating an essential portion of Fig. 1.

Fig. 3 is a circuit wiring diagram of an essential portion of Fig. 2.

Fig. 4 is a signal timing chart for explaining a clock pulse transmitted from a clock pulse generator shown in Fig. 1.

Fig. 5 is a circuit block diagram of a modification of the circuit shown in Fig. 2.

Fig. 6 is a circuit block diagram of another modification of the circuit shown in Fig. 2.

Fig. 7 is a circuit block diagram of a second preferred embodiment of a data storing apparatus according to the present invention.

Fig 8. is a circuit block diagram of a third preferred embodiment of a data storing apparatus according to the present invention.

Fig. 9 is a circuit block diagram of an essential portion of the circuit shown in Fig. 8.

Fig. 10 is an internal circuit wiring diagram of the circuit shown in Fig. 8.

Fig. 11 is a circuit block diagram of another circuit construction of a shift registor shown in Fig. 8.

Fig. 12 is a circuit block diagram of a modification of the circuit shown in Fig. 8.

Fig. 13 is a circuit block diagram of a fourth preferred embodiment of a data storing apparatus according to the present invention.

## DETAILED DESCRIPTION OF THE PREFERRED EMBODIMENTS

Reference will hereinafter be made to the drawings in order to facilitate understanding of the present invention.

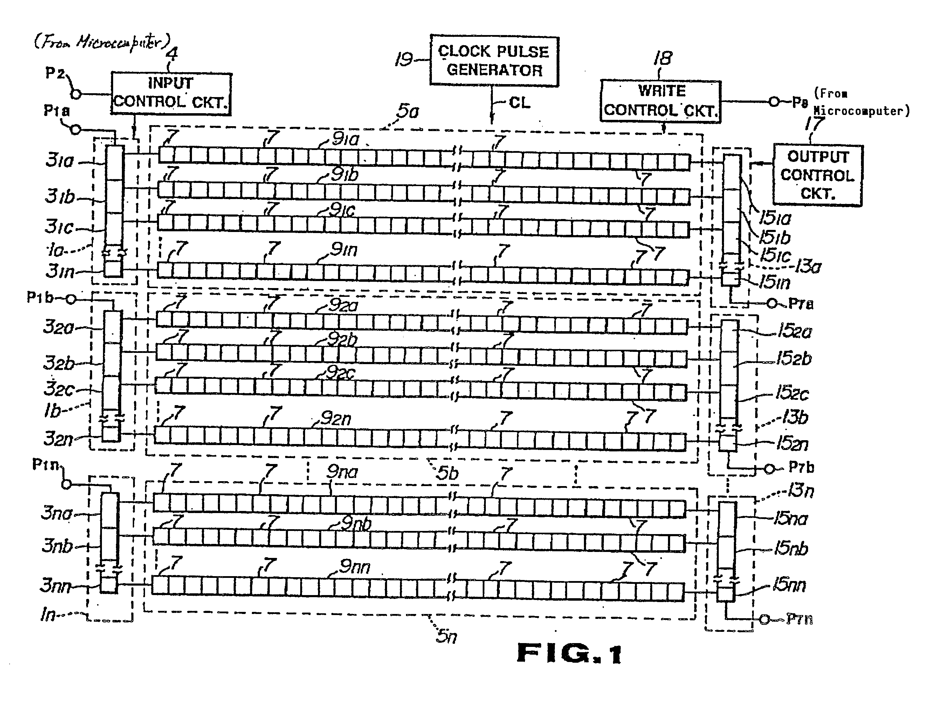

Fig. 1 shows a first preferred embodiment of a data storing apparatus according to the present invention.

In Fig. 1, a plurality of registers are arranged in series with a plurality of data input portions $1a$, $1b$, ---, $1n$. For example, respective registers $3_1a$, $3_1b$, $3_1c$, ---, $3_1n$, are connected in series (cascade connection) in a longitudinal direction in one of the data input portion $1a$. In addition, respective registers $3_1a$, $3_1b$, $3_1c$, ---, $3_1n$ are connected in series in the longitudinal direction. Similarly, respective registers $3_na$, $3_nb$, $3_nc$, ---, $3_nn$ are arranged in series in the longitudinal direction.

The register $3_1a$ is connected an input terminal $P_1a$. Similarly, the register $3_2a$ is connected to the input terminal $P_1b$. The register $3_na$ is connected to the input terminal $P_1n$.

Various data on the run of a vehicle are inputted in parallel into a plurality of input terminals $P_1a$, $P_1b$, ---, $P_1N$, respectively. For example, the data on a switch signal is inputted to the input terminal $P_1a$. In addition, a data on a revolution speed of an engine in inpuuted to the input terminal $P_1b$. A data on the speed run derived from the vehicle speed sensor is supplied to the input terminal $P_1c$. A data read from a fuel supply system of the engine is inputted into the input terminal $P_1d$. Furthermore, a data on various kinds of control signals is inputted into the input terminal $P_1n$.

These respective data on the run of the vehicle are constituted by a plurality of bits. Each data comprising the plurality of bits is supplied to the corresponding input terminal in the form of a serial data.

Each of the input portions $1a$, $1b$, ---, $1n$ is connected to an input control circuit 4, each input portion $1a$, $1b$, ---, $1n$ being controlled on the basis of instructions from the input control circuit 4.

That is to say, the input control circuit 4 receives an instruction signal from a microcomputer via a terminal $P_2$ to execute an input control for the data on the basis of the inputted instruction signal.

Each of the plurality of data input portions $1a$, $1b$, ---, $1n$ is connected to a corresponding storage block $5a$, $5b$, $5c$---, $5n$.

A construction of typical one of the storage blocks $5a$, $5b$ ---, $5n$ will be described in details below.

In the storage block $5a$, a registor string $9_1a$ is connected to a registor $3_1a$. The registor string $9_1a$ includes a plurality of shift registors 7 arranged in series in a lateral direction. A registor string $9_1b$ is connected to another registor $3_1b$. The registor string $9_1b$ includes a plurality of shift registors 7 arranged in series in the lateral direction. The registor string $9_1c$ is connected to another registor $3_1c$. the registor string $9_1c$ includes a plurality of shift registors 7. Furthermore, a registor string $9_1n$

includes a plurality of shift registers 7 arranged in series in the lateral direction. The register string $9_1n$ is connected to another register $3_1n$.

A construction of such a storage block 5a is the same as that of each of the other storage blocks 5b, ---, 5n.

That is to say, a registor $3_2a$ is connected to a registor string $9_2a$. A registor $3_2b$ is connected to a registor string $9_2b$. A registor $3_2n$ is connected to a registor string $9_2n$. In the same way, in the storage block $5_n$, a register string $9_na$ is connected to a registor string $9_na$. A registor $3_nb$ is connected to a registor string $9_nb$. A registor $3_nn$ is connected to a registor string $9_nn$.

Each of a plurality of storage blocks 5a, 5b, ---, 5n is connected to a corresponding data output portion 13a, 13b ---, 13n.

A construction of a typical one of the plurality of data output portions 13a, 13b, ---, 13n will be described in details below.

The data output portion 13a includes a plurality of registors $15_1a$, $15_1b$, $15_1c$, ---, $15_1n$ arranged in series in the longitudinal direction. The register $15_1a$ is connected to the register string $9_1a$. The register $15_1b$ is connected to the register string $9_1b$. The registor $15_1c$ is connected to the register string $9_1c$. The registor $15_1n$ is connected to the register string $9_1n$.

An internal construction of the data output portion 13a is the same as that of each of the other data output portions 13b, 13c, ---, 13n.

That is to say, in the data output portion 13b, the registor $15_2a$ is connected to the register string $9_2a$. The registor $15_2b$ is connected to the register string $9_2b$. The registor $15_2c$ is connected to the register string $9_2c$. The registor $15_2n$ is connected to the register string $15_2n$.. In the same way, the registor $15_na$ is connected to the register string $9_na$. The registor $15_nb$ is connected to the register string $9_nb$. The registor $15_nn$ is connected to the register string $9_nn$.

Each of the plurality of data output portions 13a, 13b. ---, 13n is connected to an output control circuit 17. Each of the data output portions 13a, 13b, ---, 13n is controlled on the basis of an instruction derived from an output control circuit 17. That is to say, the output terminal $P_7a$ is connected to the registor $15_1n$. The output terminal $P_7b$ is connected to the register $15_2n$. The output terminal $P_7n$ is connected to the register $15_nn$. The plural kinds of data stored respectively in the storage blocks 5a, 5b, ---, 5n based on the instructions derived from the output control circuit 17 are sequentially outputted in the serial data form via corresponding output terminals $P_7a$, $P_7b$, ---, $P_7n$ corresponding to the respective kinds of data.

In addition, a signal for reading a data stored in a non-volatile storage portion NV in the shift register 7 as will be described later is transmitted to each of the plurality of storage blocks 5a, 5b, ---, 5n, respectively.

The write control circuit 18 is connected to each of the storage blocks 5a, 5b, ---, 5n for controlling a write of data in a unsteady condition such as in the case of emergency.

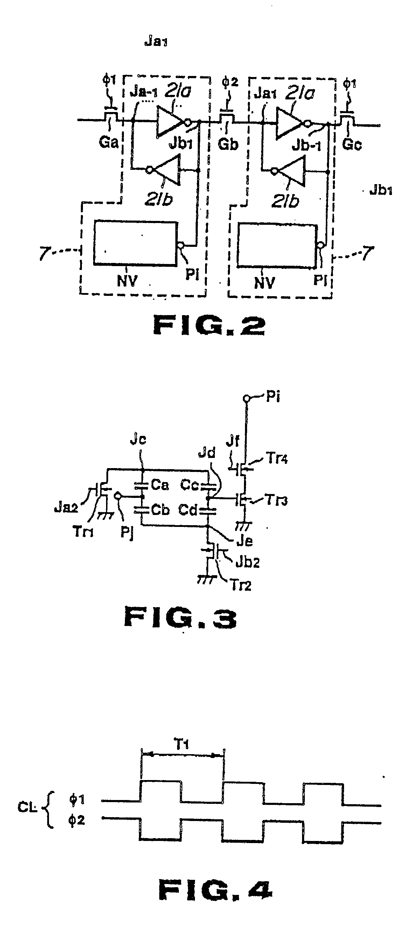

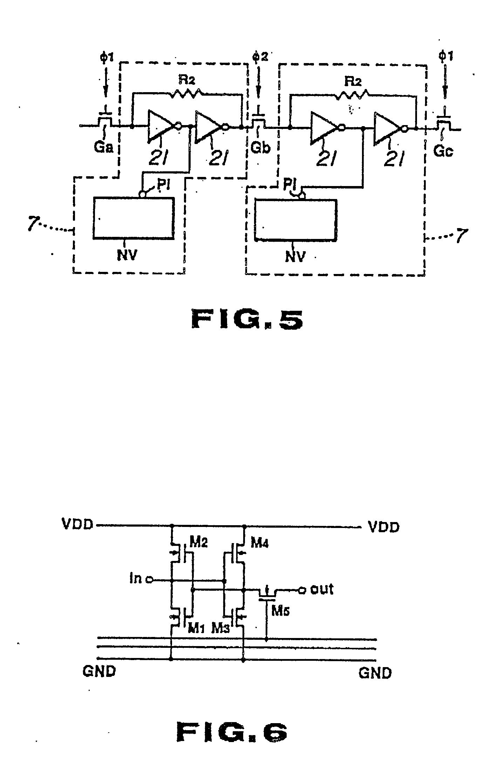

A clock pulse generator 19, e.g., two stages of shift registers shown in Fig. 2 and 5 as will be described later. As shown in Fig. 4, a clock pulse CL constituted by two clock pulses $\varphi_1$ and $\varphi_2$ each having a predetermined period $T_1$ is transmitted to each of the plurality of storage blocks 5a, 5b ---, 5n. Hence, the data stored in each of the shift registers 7 in the register strings constituting the corresponding storage block are sequentially shifted in the rightward direction in synchronization with the clock pulse CL having the predetermined period $T_1$. The data shifted sequentially in the rightward direction will vanish at a trailing end of the corresponding register string. Hence, in order to input the data on the run of the vehicle for each predetermined record interval time $T_r$ and to hold a prior data for $T_p$ second with respect to the present time, a number of shift registers 7 relatively corresponding to $(T_r/ T_p)$ and a multi-phase clock pulse corresponding to the shift registers are needed for each register string.

Next, an internal construction of the shift register 7 shown in Fig. 1 will be described with reference to Fig. 2.

In Fig. 2, two shift registers 7 and 7 are shown, each shift register 7 including two invertors 21a, 21b and a non-volatile memory NV.

That is to say, one invertor 21a is reversely connected to the other invertor 21b (parallel connection but polarity thereof is reversed). A data output side of the two invertors is connected to the non-volatile memory NV via a terminal $P_i$. A current drive capability (current supply capacity) of the other invertor 21b is set lower than that of the one invertor 21a. A gate Gb is intervened between two registors 7, 7. Respective gates $G_a$ and $G_c$ are connected to other adjacent registers (not shown). The one gate $G_a$ receives a predetermined clock pulse $\varphi_1$ and the other gate Gb receives a predetermined clock pulse $\varphi_2$. In addition, a predetermined clock pulse $\varphi_2$ is supplied to the gate $G_b$. The gate $G_c$ receives the clock pulse $\varphi_1$. Hence, the data inputted from the leftward direction is sequentially shifted toward the rightward direction in synchronization with each of the clock pulses $\varphi_1$, $\varphi_2$, $\varphi_1$. A single memory element is constituted by the invertor 21a and invertor 21b. The data recorded in the single memory element is stored and held in the non-volatile memory NV corresponding to the data. That is to say, the non-volatile memory portion NV constitutes holding means for holding the data stored in the memory element in the unsteady state as in the case of emergency.

An internal construction of the non-volatile memory portion NV shown in Fig. 2 will be described below with reference to Fig. 3.

As shown in Fig. 3, four, so-called, MOS type transistors are incorporated. An electrical potential at a junction $J_{a2}$ at a gate side of the MOS transistor $T_r1$ is set at the same potential as a junction $J_{a1}$ at an input side of the memory element shown in Fig. 2.

In a case where the electrical potential at the junction $J_{a1}$ at an input side of the memory element constituted by the two invertors 21a, 21b is at a high (H) level, the electrical potential at the junction $J_{a2}$ of the non-volatile memory portion NV is also set at the high (H) level. The MOS transistor $T_r1$ is connected to a capacitor $C_a$ and a capacitor $C_c$ via a junction $J_c$. The capacitor $C_a$ is connected to the capacitor $C_b$. A terminal $P_j$ is provided from a junction between the capacitors $C_a$ and $C_b$. The terminal $P_j$ is connected to a write control circuit 18 shown in Fig. 1. When the data is stored into the non-volatile memory portion NV from the corresponding memory element, a high voltage pulse from the write control circuit 18, e.g., a voltage pulse from about 15 volts to about 25 bolts is applied to the terminal $P_j$.

The output timing of the high voltage pulse will be explained which is to be transmitted from the write control circuit 18. While the write control circuit 18 monitors the transmission of the clock pulse CL from the clock pulse generator 19, the transmission of the high voltage pulse is inhibited in a state where the clock pulse CL is transmitted from the clock pulse generator 19. That is to say, in a case where a signal indicating that it is in the unsteady state such as in the case of emergency is received via the terminal $P_8$, the write control circuit 18 transmits the high voltage pulse to the terminal $P_j$ of the non-volatile memory portion NV after the transmission of the clock pulse CL is ended from the clock generator 19.

In addition, the terminal $P_j$ is connected to the output control circuit 17. When the data is read which is stored and held into the non-volatile memory portion NV, a predetermined reference voltage $V_r$ is supplied to the terminal $P_j$ which is lower than the pulse voltage of the high voltage pulse as the signal indicating that the data held from the output control circuit 17 is read.

A series circuit constituted by the capacitors $C^a$ and $C_b$ is connected in parallel with a series circuit constituted by the capacitors $C_c$ and $C_d$.

The capacitor $C_d$ is constituted by a thin film capacitor, for example, formed of an oxide thin film having a film thickness of about 100 . The capacitor $C_d$ is connected to a MOS type transistor $T_r2$ via a junction $J_e$. The electrical potential at the junction $J_b2$ of the gate of the MOS type transistor $T_r2$ is set at the same potential as that of the output end of the memory element corresponding to Fig. 2.

When the junction $J_b1$ at the output side of the memory element formed with the two invertors 21a, 21b is at the L level, the electrical potential at the junction $J_b2$ of the non-volatile memory portion NV is also set at the L (low) level.

It is noted that a junction between the capacitors $C_c$ and $C_d$ is connected to the gate of the MOS type transistor $T_r3$. The MOS type transistor $T_r3$ is a transistor for a current output. In a case where the electrical potential at the gate side, i.e., the junction $J_d$ is at a predetermined threshold voltage $V_{thr}$, this case corresponds to the case where the data at the junction $J_a1$ at the input side of the corresponding memory element is at the high (H) level. On the contrary, in a case where the electrical potential at the junction $J_d$ is at a threshold voltage $V_{thh}$ higher than the threshold voltage $V_{thr}$, the data in a case where the electrical potential at the junction $J_a1$ at the output side of the corresponding memory element is at the L level.

The MOS type transistor $T_r3$ is connected to the corresponding memory element via the MOS type transistor $T_r4$ and terminal $P_i$. The junction $J_f$ at the gate of the MOS type transistor $T_r4$ is connected to the output control circuit 17. A switching operation is carried out on the basis of the signal from the output control circuit 17.

Next, an operation of holding the data in the unsteady state such as the case of emergency.

A data for each bit is sequentially shifted into a subsequent shift registor in the plurality of series-connected shift registors of the plurality of shift registor strings. From among the plurality of series-connected shift registors 7, the particular shift registor 7 as shown in Fig. 2 will be described.

Suppose that the junction $J_a1$ of two invertors 21a, 21b shown in Fig. 2 at the input side of the memory element is at the high (H) level and the junction $J_b1$ at the output side of the memory element is at the low (L) level side. In addition, suppose that the write control circuit 18 shown in Fig. 1 is inputted via the terminal $P_8$, the signal on the unsteady state such as the emergency signal derived from the sensor. The write control circuit 18 transmits a predetermined high voltage pulse to a terminal $P_j$ of the non-volatile memory portion NV shown in Fig. 3. Since the junction $J_a1$ at the memory element side is at the high (H) level, the junction $J_a2$ at the non-volatile memory portion NV is also set to the high (H) level. Similarly, since the junction $J_b2$ at the non-volatile memory portion NV is also set to the L (low) level, the junction $J_b2$ at the non-volatile memory portion NV is also set to the low (L) level.

Since the junction $J_a2$ shown in Fig. 2 is at the high (H) level, the MOS type transistor $T_r1$ is conducted. In addition, since the junction $J_b2$ is at the low (L) level, the MOS type transistor $T_r2$ is set to the off state. When a predetermined high voltage pulse is given to the terminal $P_j$ with the junction $J_b2$ at the low (L) level, the MOS type transistor $T_r2$ is set to the off state.

In this way, when the junction $J_a2$ is at the high level and the junction $J_b2$ is set at the L level, a predetermined high voltage pulse is given to the terminal $P_j$ with the junction $J_b2$ set at the low level (L). At this time, the electrical potential at the junction $J_e$ is pulled up with the electrical potential of the junction $J_e$ maintained at the zero volt. That is to say, the applied voltage so that the electrical potential at the junction $J_e$ is supplied across both terminals of the capacitor $C_d$. Therefore, so-called tunnel effect is generated, the electrons being discharged from the junction through the oxide film of the capacitor $C_d$. If such tunnel effect as described above is generated, the electrical potential at the junction $J_d$ becomes lowered. The junction $j_d$ at the MOS type transistor $T_r3$ becomes lowered so as to set to the predetermined threshold voltage $V_{thr}$. In this way, since the electrical potential of the junction $J_d$ at the gate of the MOS type transitor $T_r3$ is set to the predetermined threshold voltage $V_{thr}$, the junction $J_a1$ at the memory element side corresponds to the case where the junction $J_a1$ at the memory element side is at the high (H) level data.

In a case where the junction $J_a1$ at the input side of the memory element is at the low (L) level side, such a data is held in the non-volatile memory portion NV. The reverse operation is carried out. That is to say, with the junction $J_a2$ set at the low (L) level, the junction $J_b2$ is set at the high (H) level. A predetermined high voltage pulse from the write control circuit 18 to the terminal $P_j$ under such a state is supplied. At this time, the electrons through the thin film of the capacitor $C_d$ are injected into the junction $J_d$. The electrical potential of the junction $J_d$ at the gate of the MOS type transistor $T_r3$ is set to the predetermined threshold voltage $V_{thh}$ so that the junction $J_a1$ at the memory element side is at the low (L) level.

As described above, the data of the memory element at the electrical potential of the MOS type transistor $T_r3$ is set according to the data of the memory element. Therefore, the protective holding of data of the memory element is assured.

When an analysis on the operation of the unsteady state is carried out, the operation in a case where the stored data in the non-volatile memory portion NV is read will be described.

In a case where the data stored in the non-volatile memory portion NV is read, the predetermined reference voltage $V_r$ is provided from the output control circuit 17 to the terminal $P_j$. As the value of the reference voltage $V_r$, the electrical potential at the junction $J_d$ is set to the voltage $V_{th\tau}$. With the MOS type transistor $T_r3$ turned on, the electrical potential at the junction $J_d$ is set at the predetermined threshold voltage $V_{thh}$. On the contrary, in a case where the electrical potential at the junction $J_d$ is set to the predetermined threshold voltage $V_{thh}$, the value of voltage is set so as to turn the MOS type transistor $T_r3$ off in a case where the electrical potential at the junction $J_d$ is set to the predetermined threshold voltage $V_{thh}$.

Hence, with a predetermined reference voltage $V_r$ from the output control circuit 17 provided to the terminal $P_j$, the MOS type transistor $T_r3$ is turned on or off according to the value of the threshold voltage of the junction $J_d$.

Next, for example, the signal to turn on the MOS type transitor $T_r4$ from the output control circuit 17 is supplied to the junction $J_f$ at the gate side of the MOS type transistor $T_r4$. In this way, since the signal is supplied to the junction $J_f$, the MOS type transistor $T_r4$ is turned on or off.

A signal to turn on the MOS type transistor $T_r4$, e.g., from the output control circuit 17 is supplied to the junction $J_f$. In this way, since the signal is applied to the junction $J_f$, the MOS type transistor $T_r4$ is turned on. In this way, the signal to the junction $J_f$ is supplied to turn on the MOS type transistor $T_r4$. In this way, with the MOS type transistor $T_r4$ turned on, the junction $J_b1$ at the memory element side is set to the low (L) level in a case where, e.g., the threshold voltage at the junction $J_d$ is at the $V_{th\tau}$. With the junction $J_b1$ at the memory element side set the (L) low level, the junction $J_a1$ is set at the low (H) level. In addition, in a case where the threshold voltage at the junction $J_d$ is at the voltage of $V_{thh}$, the junction $J_b1$ at the memory element side is set to the high level (H) and the junction $J_a1$ is set to the low (L) level.

The original data according to the value of the theshold voltage of the junction is read into the two memory elements 21a, 21b.

Next, the clock pulse generator 19 is operated on the basis of control instructions derived from the output control circuit 17. The predetermined clock pulse CL is outputted to respective registor strings connected in series with the registor strings in which the plurality of shift registers are connected in series.

In this way, the data read from the non-volatile memory portion NV is sequentially shifted to the subsequent shift register in synchronization with the predetermined clock pulse. The data for each bit sequentially shifted is arranged in the serial data form at the data output portion. The serial data thus arranged is outputted from the corresponding output terminal.

The data for the time $T_p$ prior to the time during which the unsteady state is generated as described above can be analyzed.

The clock pulse generator 19 shown in Fig. 1 can be incorporated into the input control circuit 4 or output control circuit 17.

In addition, in the preferred embodiment shown in Fig. 1 both single input terminal and single output terminal are installed for each kind of data on the run of the vehicle. The circuit construction can furthermore be simplified since the data input portion and data output portion can be eliminated.

Another example of the shift register 7 shown in Fig. 2 will be described with reference to Fig. 5.

Fig. 5 shows the two registors 7 and 7, each shift register 7 being constituted by two invertors 21, resistor $R_2$, and non-volatile memory portion NV. That is to say, two invertors 21 are connected in series with each other. The resistor $R_2$ is connected in parallel with the series-connected two invertors 21. The non-volatile memory portion NV is connected via the input terminal $P_i$ from the two invertors junctions 21.

A gate $G_a$ and gate $G_c$ are connected between the two shift registers 7, 7 as shown Fig. 5. In the same way, the registor 7 is connected between the other registor and the registors 7. While a predetermined clock pulse $\varphi_1$ is provided for the gate $G_c$, the gate $G_b$ receives the clock pulse $\varphi_2$. In addition, the clock pulse $\varphi_1$ is transmitted to the gate $G_b$. The clock pulse $\varphi_1$ is provided for the gate $G_c$. Hence, the data inputted in the leftward direction is shifted in the rightward direction in synchronization with the predetermined clock pulses $\varphi_1$, $\varphi_2$, and $\varphi_1$. In addition, in a state where the unsteady state such as the case of emergency, the data of the memory element formed of the two invertors 21 and resistor R is protectively held in the non-volatile memory portion NV.

Although, as shown in Fig. 2 and 5, the gate is installed between each shift register, the present invention is not limited to the embodiments shown in Fig. 2 and 5. The gate can be constructed in these registors.

As the shift registers 7 shown in Fig. 1, the so-called integrated circuits in which five transistors $M_1$, $M_2$, $M_3$, $M_4$, and $M_5$ as shown in Fig. 6 are formed.

In a case where the integrated circuits as shown in Fig. 6 are used to constitute the shift register, the number of transistors may be reduced and the cost is accordingly reduced.

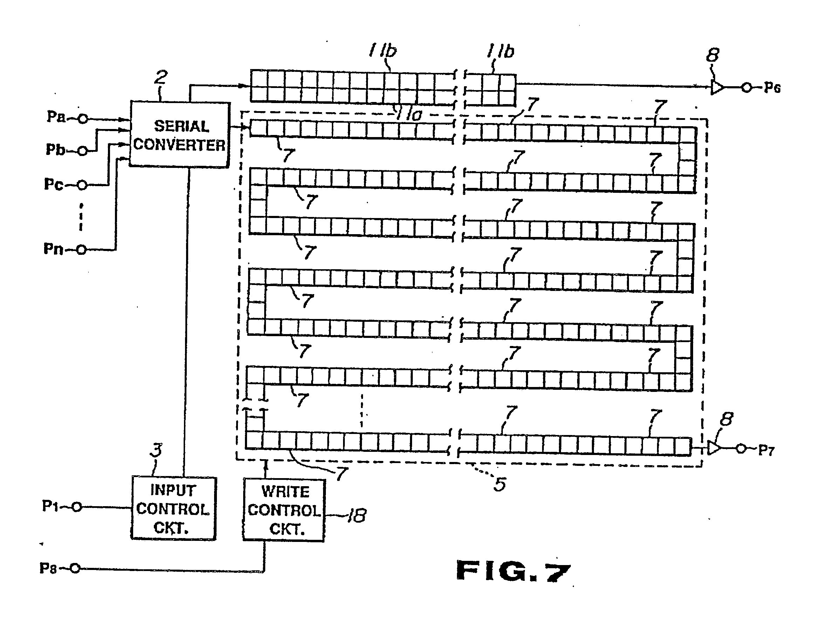

The second preferred embodiment according to the present invention will be described with reference to Fig. 7.

A plurality of shift registers 7 as the memory blocks 5 are arranged in series so that various data on the run of the vehicle are sequentially shifted in the form of the serial data.

The serial converter 2 is connected to a plurality of input terminals $P_a$, $P_b$, ---, $P_n$, respectively. These respective input terminals $P_a$, $P_b$, $P_c$, ---, $P_n$ receive the data on the vehicle run, e.g., data on the switch signal, data on the engine speed, data on the run speed from the vehicle speed sensor, data on the read signal from the fuel gage, and data on various control signals according to the allocation of the terminals to the data. These data are constituted by the plurality of bits. The various kinds of data on the run of the vehicle in the serial data form constituted by the plurality of bits are transmitted from the corresponding input terminal to the serial conversion circuit 2.

When the plurality of kinds of data are inputted via the plurality of input terminals $P^a$, $P_b$, $P_c$, ---, $P_n$, these plural kinds of data are converted into a previously set order of the serial data. The converted serial data is transmitted sequentially to the memory block 5.

The serial conversion circuit 2 is controlled on the basis of the instructions derived from the input control circuit 3. The serial conversion circuit 2 includes the clock pulse transmission circuit for transmitting the clock pulse CL having the predetermined period. The clock pulse CL having the predetermined period is transmitted to the memory block 5 and counter 11a.

The serial data outputted from the serial conversion circuit 2 is sequentially shifted in the rightward direction in synchronization with the clock pulse CL having the predetermined period. The sequentially shifted serial data are sequentially vanished in a last stage of shift registers 7 in the memory block 5. Hence, in a case where the interval of time taken for the data on the vehicle to store is $T_r$ and the bit number of the serial data to be transmitted from the serial conversion circuit 2 is K, the number N of shift registers 7 as shown below are required to hold the prior data for the time $T_p$ by the time generated in the unsteady state.

$$N = K \times T_r / T_r$$

In addition, a plurality of counters 11a for indicating the position of the data present in the memory block 5. The non-vilatile memory portion 11b is installed for each of the plurality of counters 11a. The position of the plural kinds of data is recorded by counting the clock pulse CL having the predetermined period transmitted from the serial conversion circuit 2. The position of data thus recorded is stored and held into the non-volatile memory portion 11b correspondingly installed.

The number M of the plurality of counters 11a is set as follows.

$$M = \log_2 N$$

In addition, the information on the position of the data stored in the non-volatile memory portion 11b is outputted via the buffer circuit 8 and terminal $P_6$.

The buffer circuit 8 is, e.g., controlled on the basis of control instructions derived, e.g., from the write control circuit 18. The buffer circuit 8 is set in the output inhibit state in a predetermined time for which the data on the vehicle run is inputted.

Such suitable shift registers as shown in Fig. 5 or Fig. 6 may be used as the plurality of shift registers 7.

In addition, a non-volatile memory portion 11b may be used as the non-volatile memory portion 11b shown in Fig. 3.

Although, in the example shown in Fig. 7, a plurality of input terminals are installed for each kind of data on the run of the vehicle. A plurality of input terminals may be installed for each bit of each data of the plural kinds, the plurality of input terminals may be installed for each bit of the respective data.

Alternatively, when the single input terminal is installed in place of the plurality of input terminals, the serial conversion circuit 2 is installed externally, and the data is inputted from the serial conversion circuit 2 via the single input terminal, the circuit construction of the data memory apparatus may be simplified.

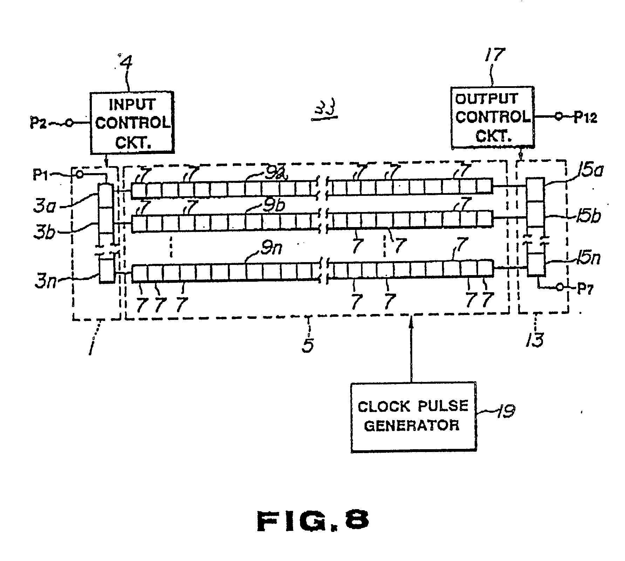

A third preferred embodiment of the data storing apparatus will be described below with reference to Figs. 8 to 12.

As shown in Fig. 8, the data input portion 1 includes the respective registors 3a, 3b, 3c, ---, 3n arranged in series in the longitudinal direction. The registor 3a is connected to the input terminal $P_1$. Various kinds of data on the run of the vehicle are constituted by the plurality of bits. The various kinds of data constituted by the plurality of bits are sequentially inputted via the input terminals $P_1$. The data input portion 1 is connected to the input control circuit 4, the data input portion 1 being controlled on the basis of instructions derived from the input control circuit 4. In addition, the data input portion 1 is connected to the memory block 5.

The details of the construction of the memory block 5 will be described below.

A resistor string 9a is connected to a plurality of shift registers 7 are arranged in series in the lateral direction. In addition, the registor 3b is connected to the registor string 9b in which the plurality of shift registers 7 are arranged in series in the lateral direction. The registor 3c is connected to the registor string 9c in which the plurality of shift registers 7 are arranged in series in the lateral direction. Furthermore, the registor 3n is connected to the registor string 9n in which the plurality of registors 7 are arranged in series in the lateral direction.

The memory block 5 is connected to the data output portion 13. The data output portion 13 includes the plurality of registors 15a, 15b, 15c, ---, 15n in series in the longitudinal direction. The registor 15a is connected to the registor string 9a. The registor 15b is connected to the registor string 9b. The registor 15n is connected to the registor string 9n. Furthermore, the data output portion 13 is controlled on the basis of instructions derived from the output control circuit 17. That is to say, the output terminal $P_7$ is connected to the register 15n. A plural kinds of data stored in the memory block 5 on the basis of instructions derived from the output control circuit 17 are sequentially outputted via the terminal $P_7$ for each kind of data.

The clock pulse generator 19 is the same as the example shown in Fig. 1. The clock pulse CL having the predetermined period is transmitted as shown in Fig. 4.

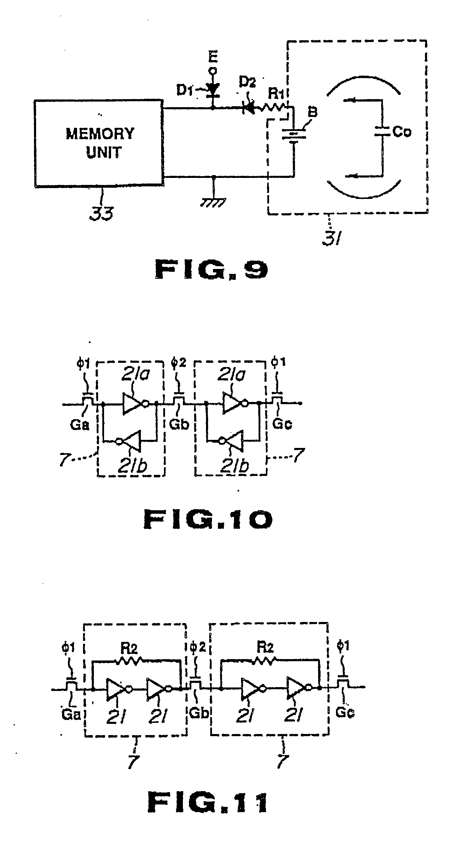

A back-up of the data storing apparatus 33 shown in Fig. 8 will be described with reference to Fig. 9.

The data storage apparatus 33 as shown in Fig. 9 is connected to a predetermined DC power supply E via a diode $D_1$. A power supply voltage from a predetermined DC power supply E is supplied to the data storage apparatus 33 via a diode $D_1$ connected in the forward direction. In addition, the data storage apparatus 33 is connected to a battery B via a diode $D_2$ and resistor $R_1$. In a case where the power supply from the DC power supply E is broken in the unsteady state, the power supply from the battery B is supplied to the data storage apparatus 33 via the resistor $R_1$ and diode $D_2$.

Alternatively, in place of the battery B, a capacitor $C_0$ having a predetermined capacity may be connected to the data storage apparatus 33. The capacitor $C_0$ charges the power supply from the predetermined DC power supply E at the normal time. In the case of unsteady state in which the power supply from the DC power supply is interrupted, the charged voltage from the capacitor $C_0$ may be supplied to the data storage apparatus.

A stand-by power supply circuit 31 in which the battery B or capacitor $C_0$ is incorporated constitutes holding means for holding the data stored in the data storage apparatus 33 in a case where the power supply is interrupted.

Fig. 10 shows an internal construction of each shift register 7 shown in Fig. 8.

In Fig. 10, two shift registers 7, 7 are shown in which respective two invertors 21a and 21b are connected in parallel to each other in mutually reversed direction. The current drive capability of the invertor 21b is set lower than the current drive capability of the invertor 21a.

For example, when the gate $G_b$ is open and the data of the shift register 7a is inputted into the shift register 7b, the data inputted from the shift register is latched in the shaft register 7b. A predetermined clock pulse $\varphi_2$ is provided for the gate $G_b$ connected between the invertor 21a of the shift register 7a and the invertor 21a of the shift register 7b. A clock pulse $\varphi_1$ for the gates $G_a$ and $G_c$ is provided. Hence, the data inputted via the gate $G_a$ is sequentially shifted in the rightward direction in synchronization with the clock pulse $\varphi_1$.

Another example of the shift register 7 shown in Fig. 8 will be described with reference to Fig. 11.

In each shift register 7, a gate $G_b$ is connected between each of the shift registers 7, 7. In addition, the gates $G_a$ and $G_b$ are connected to the other adjacent shift registers. Predetermined clock pulses $\varphi_1$, $\varphi_2$, and $\emptyset_1$ are provided for these gates $G_a$, $G_b$, and $G_c$.

Hence, in the example shown in Fig. 11, when the data is inputted in the leftward direction, the data are sequentially shifted in the rightward direction in synchronization with the clock pulses $\varphi_1$, $\varphi_2$, and $\varphi_1$.

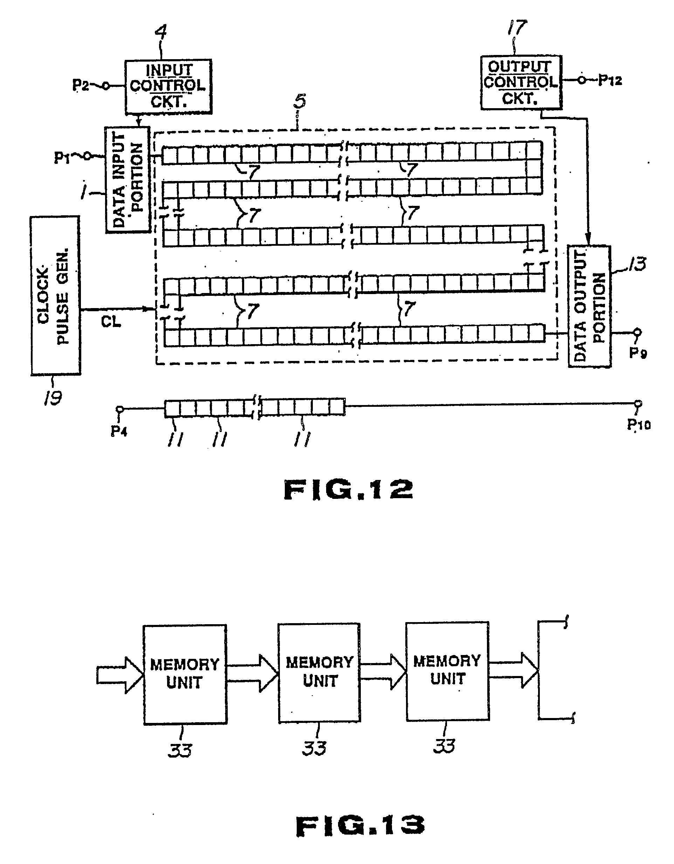

Another example of the data storage apparatus shown in Fig. 8 will be described with reference to Fig. 12.

The plurality of shift registers 7 formed of the memory block 5 are arranged in series in the example shown in Fig. 12.

Hence, when the plural kinds of data are sequentially inputted in the form of the serial data form via the input terminal. At this time, the data is sequentially shifted in synchronization with the clock pulse CL in the memory block 5.

In addition, the counter 11 indicating that the position of various kinds of data within the storage block 5 is provided in the example shown in Fig. 12.

In the preferred embodiment shown in Fig. 12, a plural kinds of data inputted through the terminal $P_1$ are sequentially shifted in the form of the serial data, the plurality of shift registers 7 constituting the memory block 5 being arranged in series connection. Therefore, the circuit constructions of the data input portion 1 and data output portion 13 can be simplified.

In addition, in a case where the shift register 7 shown in Figs. 8 and 12 includes the shift register having the non-volatile memory portion NV shown in Fig. 2 or Fig. 5, the information on the run of the vehicle can more protectively be stored and held.

A fourth preferred embodiment of the data storing apparatus according to the present invention will be described with reference to Fig. 13.

A plurality of the data storing apparatus 33 are connected in series in the example shown in Fig. 13.

Each data storing apparatus 33 shown in Fig. 13 includes the data storing apparatus shown in Fig. 8 or Fig. 12.

As the shift register 7 incorporated into the data storing apparatus 33, the shift register having the non-volatile memory portion NV can be constituted. In addition, the shift register shown in Fig. 6 may be used as the shift register 7.

Although it is necessary to provide additional addresses in the case of previously proposed data storing apparatus when such an alternation as expansion of memory capacity is carried out, the data storing apparatus in the fourth preferred embodiment, a mere direct connection may be carried out but a modification can easily be made.

As described hereinabove, although the erase and write of the data need to be carried out repeatedly in the case of the previously proposed data storing apparatus, the mere write of the data can cause the sequential and automatic storage of the data. Since the data stored in the storage means in the unsteady state is held by means of holding means, the high speed processing with the low-cost apparatus becomes possible as compared with the case where the control of erase and write of data can always be carried out and the data can protectively be secured therein in the case of unsteady state such as in the case of emergency.

It will be fully appreciated by those skilled in the art that the foregoing description has been made in terms of the preferred embodiments and various changes and modifications may be made without departing from the scope of the present invention which is to be defined by the appended claims.

## Claims

1. An apparatus for storing data therein, comprising:
   a) first means for producing and outputting a clock pulse signal having a predetermined period;
   b) second means for controlling a plurality of data, each having a plurality of bits, to be inputted into the data storing apparatus in synchronization with the clock pulse signal; and
   c) third means having a plurality of data memory portions for storing respective bits of data and for shifting and respective bits of data toward the subsequent data memory portions thereof in synchronization with the clock pulse signal.

2. An apparatus as set forth in claim 1, which further comprises d) fourth means for holding the data stored in the third means when an unsteady state of an object to provide the data occurs.

3. An apparatus as set forth in claim 2, wherein the second means includes a plurality of data input portions, each data input portion including a plurality of shift registers arranged in series with one another and a data input terminal for receiving each of the plurality of data, and an input control circuit for executing the input control of each data input portion in response to a command derived from a microcomputer.

4. An apparatus as set forth in claim 3, wherein the third means includes a plurality of shift registor strings, each shift register string connected to one of the shift registers of each data input portion.

5. An apparatus as set forth in claim 4, wherein the fourth means includes fifth means for producing and outputting an emergency signal when the unsteady state occurs and a write control circuit for receiving the emergency signal from the fifth means and providing a high voltage pulse for each shift registor of each shift registor string for protectively holding the data in each shift registor string.

6. An apparatus as set forth in claim 5, which further comprises sixth means for outputting the plurality of data stored in the third means in synchronization with the clock pulse signal in response to a write command derived from the microcomputer.

7. An apparatus as set forth in claim 5, wherein each shift register of each registor string in the third means includes: a) a transmission gate connected to an adjacent one of the shift registers for passing each shifted bit of data therethrough in response to the clock pulse signal derived from the first means, b) a pair of first and second invertors, the first invertor being connected to the transmission gate, being connected in parallel with the second invertor in a mutually reverse direction, and having a high current supplying capacity than the second invertor, and a non-volatile memory portion having a first terminal for receiving the high voltage pulse from the write control circuit and a second terminal connected to the pair of the first and second invertors.

8. An apparatus as set forth in claim 7, wherein the non-volatile memory portion includes: a) a first MOS type transistor, connected to the ground, which turns on or off according to a status of one of the bits of data at an input side of the first invertor; b) a second MOS type transistor, connected to the ground, which turns on or off according to the status of one of bits of data at an output side of the first invertor; c) four capacitors, a first capacitor connected between the first MOS type transistor and the first terminal, a second capacitor connected between the first terminal and the second MOS type transistor, a third capacitor connected to the first MOS type transistor, and a fourth capacitor connected between the second MOS type transistor and third capacitor; d) a third MOS type transistor, a gate thereof connected to a junction between the third and fourth capacitors, and e) a fourth MOS type transistor connected between the third MOS type transistor and the second terminal.

9. An apparatus as set forth in claim 8, wherein the fourth capacitor is of a thin film capacitor.

10. An apparatus as set forth in claim 8, wherein the input of the clock pulse signal to the transmission gate has a higher priority than the input of the high voltage pulse to the first terminal.

11. An apparatus as set forth in claim 5, wherein each shift register of each shift registor string in the third means includes a transmission gate connected to an adjacent one of the shift registers for passing each shifted bit data therethrough in response to the clock pulse signal from the first means, a pair of first and second invertors, the first invertor connected to the transmission gate and to an input side of the second invertor and having a higher current supplying capacity than the second invertor, a feedback registor connected between an input side of the first invertor and an output side of the second invertor, and a non-volatile memory portion having a first terminal for receiving the high voltage pulse from the write control circuit and a second terminal connected to the pair of the invertors.

12. An apparatus as set forth in claim 2, wherein the second means includes: a parallel-to-serial convertor having a plurality of input terminals for receiving the plurality of data at the same time and converting each of the data into a bit serial form and an input control circuit for executing the input control of the parallel-to-serial conversion circuit in response to an input command derived from a microcomputer.

13. An apparatus as set forth in claim 12, wherein the third means comprises a string of shift registers having the plurality of shift registers arranged in series with one another.

14. An apparatus as set forth in claim 13, which further comprises a plurality of counting circuits for deriving a position of each data within the string of the shift registers in synchronization with the clock pulse signal.

15. An apparatus as set forth in claim 14, wherein the first means is incorporated into the input control circuit.

16. An apparatus as set forth in claim 14, which further comprises sixth means for outputting the plurality of data stored in the third means in synchronization with the clock pulse signal in response to an read command derived from the microcomputer.

17. An apparatus as set forth in claim 16, wherein the sixth means comprises an output buffer connected to one end of the string of the shift registers.

18. An apparatus as set forth in claim 2, wherein the second means includes a data input portion including a plurality of shift registers arranged in series with one another and an input control circuit for executing an input control of the data input portion so as to serially input the data in the input data portion in response to an input command derived from a microcomputer.

19. An apparatus as set forth in claim 18, wherein the third means includes a plurality of shift register strings, each shift register string connected to one of the shift registers of the data input portion.

20. An apparatus as set forth in claim 19, which further includes a power supply circuit (E) connected to the data storing apparatus via a first diode ($D_1$) for supplying a power supply voltage to the data storing apparatus in a normal time via the forward first diode and a DC battery connected to the data storing apparatus via a resistor (R) and a second diode for supplying a DC voltage to the data storing apparatus via the second diode and resistor when the non-steady state occurs and the power supply from the power supply circuit is interrupted.

21. An apparatus as set forth in claim 20, which further includes a power supply circuit (E) connected to the data storing apparatus via a first diode ($D_1$) for supplying a power supply voltage to the data storing apparatus in a normal time via the forward first diode and a voltage charged capacitor connected to the data storing apparatus via a resistor (R) and a second diode for supplying the charged voltage to the data storing apparatus via the second diode and resistor when the non-steady state occurs and the power supply from the power supply circuit is interrupted.

22. An apparatus as set forth in claim 19, wherein each shift register of each shift register string includes a transmission gate for passing each of the bits of data therethrough in response to the clock pulse signal derived from the first means and a pair of first and second invertors connected in parallel with each other in a mutually reverse direction and to the transmission gate, the first invertor having a higher current supplying capacity than the second invertor.

23. An apparatus as set forth in claim 19, wherein each shift register of each shift register string includes a transmission gate for passing each of the bits of data therethrough in response to the clock pulse signal derived from the first means, a pair of first and second invertors connected in series with each other, and a feedback register connected between an input side of the first invertor and an output side of the second invertor.

24. An apparatus as set forth in claim 19, wherein the third means includes a string of a plurality of shift registers arranged in series with one another and a string of counters arranged in series with one another for deriving a position of each data stored in the shift register string from the number of clock pulse signal derived from the first means.

25. An apparatus as set forth in claim 18, wherein the data storing apparatus includes a plurality of the data storing apparata arranged in series with one another.

26. An apparatus as set forth in claim 4, wherein the number of the shift registers in each shift register string corresponds at least to the following equation: $n = T_r / T_p$, wherein $T_r$ denotes a predetermined record interval of time during which the data on a run of a vehicle are inputted into the corresponding data input portion, and $T_p$ denotes a time by which the present time has passed from the time at which the unsteady state occurs and for which the prior data are held.

27. An apparatus as set forth in claim 24, wherein each counter of the counter string includes a non-volatile memory portion.

28. An apparatus as set forth in claim 27, wherein the number of the counters in the counter string corresponds to the following equation: $M = \log_2 N$, wherein N denotes the number of the shift registers in the shift register string.

29. An apparatus as set forth in claim 7, wherein the first means transmits the clock pulse to each transmission gate of the shift registers constituted by each shift register string, the clock pulse signal including first clock pulse and second clock pulse, the first and second clock pulses having the same predetermined period ($T_1$) and inversed phase with each other and being alternatingly transmitted to each transmission gate.

30. An apparatus for storing data on a run of a vehicle therein, comprising:

a) first means for producing and outputting a clock pulse signal having a predetermined period;

b) second means for controlling a plurality of data, each data having a plurality of bits, to be inputted into the data storing apparatus in synchronization with the clock pulse signal;

c) third means having a plurality of data memory portions for storing respective bits of data and for shifting the respective bits of data toward the subsequent data memory portions thereof in synchronization with the clock pulse signal.

d) fourth means for protectively holding the data stored in the third means when an unsteady state of the vehicle occurs.

31. An apparatus as set forth in claim 30, wherein the second means includes a plurality of data input terminals, each input terminal receiving in parallel the data on each state of a vehicle component.

32. An apparatus as set forth in claim 30, wherein the second means includes an input terminal for serially receiving the plurality of various data on respective states of vehicle components.

**FIG.1**

EP 0 330 577 A2

EP 0 330 577 A2

Ja1

**FIG. 2**

**FIG. 3**

**FIG. 4**

## FIG.5

## FIG.6

FIG.7

EP 0 330 577 A2

**FIG.8**

**FIG. 9**

**FIG. 10**

**FIG. 11**

**FIG.12**

**FIG.13**